# EUROPEAN PATENT SPECIFICATION

(11) **EP 3 211 226 B1**
(45) Date of publication and mention of the grant of the patent: **16.01.2019**
(21) Application number: 17152148.7
(22) Date of filing: 19.01.2017
(51) Int. Cl.: B64C 39/02, F03D 1/06, F03D 17/00, G01R 31/02, F03D 80/30, G01R 31/44

(54) **METHOD OF TESTING WIND-TURBINE RECEPTOR**
VERFAHREN ZUM PRÜFEN EINES WINDTURBINENEMPFÄNGERS
PROCÉDÉ DE TEST D'UN RÉCEPTEUR D'ÉOLIENNE

(30) Priority: 26.02.2016 JP 2016035528
(43) Date of publication of application: 30.08.2017
(73) Proprietor: Mitsubishi Heavy Industries, Ltd., Tokyo 108-8215 (JP)
(72) Inventor: Matsushita, Takatoshi, Tokyo 108-8215 (JP); Ota, Keisuke, Tokyo 108-8215 (JP); Hasegawa, Osamu, Tokyo 108-8215 (JP); Imaoka, Kengo, Tokyo 108-8215 (JP); Fukami, Koji, Tokyo 108-8215 (JP)
(74) Representative: Henkel, Breuer & Partner

(56) References cited:
- WO-A1-2012/013878
- CN-A- 104 330 682
- JP-A- H04 117 121
- US-A1- 2015 267 688
- US-A1- 2016 047 850

## Description

### TECHNICAL FIELD

The present disclosure relates to a method of testing a receptor mounted to a wind turbine blade.

### BACKGROUND ART

To protect a wind turbine blade from lightning strikes, normally, a receptor (metal lightning-receiving part) is mounted to a blade surface to receive lightning strikes. A receptor is, for instance, connected to an earth wire via a down-conductor so as to guide lightning current received by the receptor to the earth wire.

For instance, EP 2518312A discloses a wind turbine power generating apparatus including a plurality of receptors disposed on the surface of a blade body so as to be exposed, and a down-conductor disposed inside the blade body and connected electrically to the receptors.

US 2016-047850A discloses an unmanned aerial device for performing a resistance, current and/or voltage measurement at an object, in particular a lightning protection measurement at a wind turbine, comprising a contact element with an electrically conductive contact area, which can be brought into contact with a surface of the object, in particular with a lightning protection receptor of a rotor blade, of a nacelle or of a tower of a wind turbine, and comprising an electrically conductive measurement cable, which, with a first end, is connected in an electrically conductive manner to the contact area, and, with a second end, can be connected to a resistance, current and/or voltage measuring device and/or a grounding contact of the object.

WO 2012-013878A discloses a device for non-destructively checking structures, and, for example, measuring the thicknesses of structures using an ultrasonic probe. The device comprises a drone, which is capable of hovering flight and which can preferably be manually and remotely piloted by an operator using a remote control, as well as an onboard measurement probe which is connected to the drone by connection means. The connection means enable the measurement probe, in contact with a surface of a structure to be checked, to be positioned and temporarily immobilized while piloting the drone.

CN 104330682A discloses a lightning strip on-off performance detector comprising a primary coil and an induced current processing circuit. The primary coil is used for being connected with 220V commercial power so that an alternating magnetic field is generated, and a lightning strip is enabled to generate induced current. The induced current processing circuit is used for detecting induced current of the loop of the lightning strip so that on-off state of the lightning strip is confirmed. The induced current processing circuit comprises a flexible roche coil, a differential amplification circuit, an active demodulation circuit, a gate circuit and a state indicating circuit which are connected in turn. The flexible roche coil is configured to wind the metal conductor of the lightning strip. The principle of electromagnetic induction is adopted, and a sensor and the lightning strip are arranged in a non-contact mode so that on-off performance of the lightning strip can be visually judged.

### SUMMARY

Meanwhile, if electric connection between a receptor disposed on the surface of a wind turbine blade and an earth wire is not secure, there is a risk of occurrence of sparks upon receipt of lightning by the receptor, which may cause damage to the wind turbine blade. In view of this, one may consider performing an electrical continuity test on a receptor of a wind turbine blade, but it is not easy to perform an electric continuity test on a receptor while a wind turbine blade is mounted to a hub.

An object of at least some embodiments of the present invention is to provide a method of testing a wind-turbine receptor whereby it is possible to perform an electric continuity test simply on a receptor of a wind turbine blade. This object is solved by a method of testing a lightning receiving receptor of a wind turbine according to claim 1.

A method of testing a receptor of a wind turbine according to the present invention comprises: a step of moving an unmanned aerial vehicle (UAV) close to the receptor of a wind turbine blade mounted to a hub of the wind turbine, and performing an electric continuity test on the receptor.

According to the above method, using a UAV makes it easier to approach the receptor of the wind turbine blade mounted to the hub, and to perform an electrical continuity test on the receptor simply. Thus, it is possible to shorten the testing time, as well as to reduce the testing costs, as compared to an electric continuity test using a vehicle for work at height

According to the invention the above method further comprises a step of forming an electric continuity test circuit including the receptor by using the UAV. The step of performing the electric continuity test includes applying a voltage to the electric continuity test circuit.

According to the above method, the electric continuity test circuit including the receptor can be readily formed by using the UAV, and thereby it is possible to improve the efficiency of continuity test works for the receptor.

In some embodiments, in the above method, the receptor is disposed on a tip portion of the wind turbine blade, and the method further comprises a step of engaging the tip portion of the wind turbine blade with a position-determining portion disposed on the UAV to retain a relative position of the UAV with respect to the receptor.

According to the above method, the tip portion of the wind turbine blade is in engagement with the position-determining portion of the UAV to retain the relative position of the UAV with respect to the receptor. Accordingly, it is possible to perform works for forming the electric continuity test circuit including the receptor efficiently by using the UAV.

In some embodiments, in the above method, the position-determining portion includes at least one of: a cap engageable with the tip portion of the wind turbine blade; a clamp configured to nip the tip portion of the wind turbine blade in response to operation of a link mechanism by being pressed against the tip portion of the wind turbine blade; or a shaping portion which is deformable so as to follow an outer shape of the tip portion by being pressed against the tip portion of the wind turbine blade.

According to the above method, making use of the position determining portion including at least one of: the cap to be in engagement with the tip portion of the wind turbine blade; the clamp configured to nip the tip portion of the wind turbine blade; or the shaping portion being deformable so as to follow the outer shape of the tip portion, makes it possible to retain the relative position of the UAV with respect to the receptor reliably. Accordingly, it is possible to perform works for forming the electric continuity test circuit including the receptor efficiently by using the UAV.

In some embodiments, in any one of the above methods, at least a part of the receptor, or at least a part of a portion of the wind turbine blade around the receptor is formed by a magnetic element. The step of forming an electric continuity test circuit includes connecting a wire to the receptor while applying a magnetic force generated by a magnetic-force generating part disposed on the UAV to the magnetic element.

According to the above method, at least a part of the receptor or a portion of the wind turbine blade around the receptor is formed by a magnetic element, and a magnetic force generated by the magnetic-force generating part is applied to the magnetic element, which makes it possible to improve the efficiency of works for connecting wire to the receptor by using the UAV (works for forming an electric continuity test circuit).

In some embodiments, in the above method, the magnetic-force generating part is configured to be rotatable relative to a body of the UAV, about two axes orthogonal to an upward-and-downward direction of the UAV.

According to the above method, the magnetic-force generating part is configured to be rotatable with respect to the body of the UAV, and thus it is possible to attract the magnetic-force generating part toward the magnetic element reliably regardless of the relative attitude of the UAV with respect to the magnetic element (receptor or a peripheral portion thereof), which makes it possible to further improve the efficiency of works for connecting wire to the receptor by the UAV.

In some embodiments, in any one of the above methods, the UAV includes a shock absorbing member including a conductive portion at least on a surface side of the shock absorbing member. The step of forming the electric continuity test circuit includes forming the electric continuity test circuit by moving the UAV to press the shock absorbing member against the wind turbine blade and connect a wire to the receptor via the conductive portion of the shock absorbing member.

According to the above method, it is possible to connect wire to the receptor via the conductive portion of the shock absorbing member while mitigating shock due to contact between the UAV and the wind turbine blade with the shock absorbing member.

In some embodiments, in any one of the above methods, the UAV includes a container storing a conductive element in a liquid form, a gel form or a powder form. The step of forming the electric continuity test circuit includes forming the electric continuity test circuit by moving the UAV to cause a portion of the wind turbine blade including the receptor to enter the container and connect a wire to the receptor via the conductive element.

According to the above method, it is possible to connect wire to the receptor via the conductive element efficiently, by operating the UAV so that a tip of the wind turbine blade enters the container storing the conductive element.

According to the invention, the UAV includes a reel provided with a wire wound around the reel. The step of forming the electric continuity test circuit includes moving the UAV close to the wind turbine blade to connect the wire to the receptor, and unwinding the wire from the reel.

According to the above method, it is possible to move the UAV close to the wind turbine blade while the wire is wound around the reel, and thus it is possible to prevent a decrease in the attitude stability of the UAV due to a drag that the wire receives if the wire is suspended from the UAV while the UAV moves upward.

In some embodiments, in the above method, the step of forming the electric continuity test circuit includes attaching the wire of the reel to the receptor by using the UAV, detaching the UAV from the reel, and allowing the reel to unreel and move downward.

According to the above method, if the reel is detached from the UAV to unreel and move down after an end of the wire is attached to the receptor, it is possible to form the electric continuity test circuit readily by a worker below the wind turbine blade recovering the other end of the wire and connecting the wire to an earth terminal.

In some embodiments, in any one of the above methods, the step of forming the electric continuity test circuit includes connecting the receptor to an earth wire via a wire suspended from the UAV. The method further comprises a step of detaching the wire from the UAV, after performing the electric continuity test on the receptor.

According to the above method, it is possible to form the electric continuity test circuit readily by connecting the receptor to the earth wire via the wire suspended from the UAV. Furthermore, by detaching the wire from the UAV after completion of an electric continuity test, it is possible to improve the attitude stability of the UAV during downward movement of the UAV upon recovery of the UAV.

In some embodiments, in any one of the above methods, the method further comprises a step of surrounding the UAV with a wind shield member mounted to at least one auxiliary UAV.

According to the above method, the UAV is covered with the windshield member mounted to the at least one auxiliary UAV, and thus it is possible to maintain the attitude stability of the UAV without being affected by wind, while the UAV approaches the receptor, or while the UAV is in a standby state near the receptor.

According to some embodiments of the present invention, using the UAV to test the receptor of the wind turbine makes it easier to approach the receptor of the wind turbine blade mounted to the hub, and to perform an electric continuity test on the receptor simply. Thus, it is possible to shorten the testing time, as well as to reduce the testing costs, as compared to an electric continuity test using a vehicle for work at height.

### BRIEF DESCRIPTION OF DRAWINGS

FIG. 1 is an overall configuration diagram of a wind turbine to which the method according to an embodiment can be applied.
FIGs. 2 to 15 are each a schematic diagram showing a method of testing a receptor according to the embodiment (see Figs.9 and 10) and a first to a twelfth example serving to explain features of the invention (see Figs.2-8, 11-15).

### DETAILED DESCRIPTION

The Embodiment of the present invention and examples serving to explain features of the invention will now be described in detail with reference to the accompanying drawings.

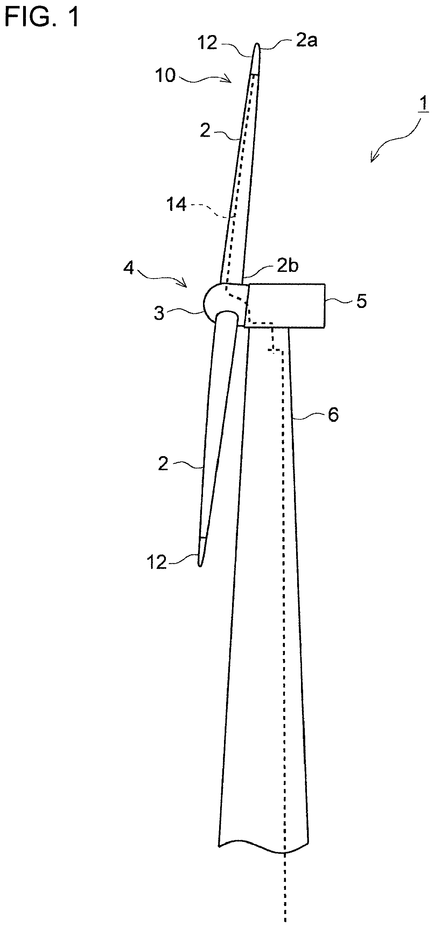

Firstly, with reference to FIG. 1, an overall configuration of a wind turbine 1, to which the method according to some embodiments can be applied, will be described. FIG. 1 is a schematic overall configuration diagram of the wind turbine 1.

For the embodiment and examples, the wind turbine 1 includes at least one wind turbine blade 2, a hub 3 to which the wind turbine blade 2 is mounted, a nacelle 5 supporting a rotor 4 including the wind turbine blade 2 and the hub 3, and a tower 6 which supports the nacelle 5 revolvably. Rotation of the rotor 4 is inputted into a non-depicted generator, and the generator thereby generates electric power. The wind turbine 1 may be installed on land, or on water such as ocean and lake.

The wind turbine 1 having the above configuration is provided with a lightning protection device 10 including a receptor 12 for receiving lightning.

The lightning protection device 10 includes the receptor 12 mounted at least to the wind turbine blade 2, and a down-conductor 14 for guiding lightning current received by the receptor 12.

The receptor 12 is formed from a conductive material (e.g. metal material). For instance, the receptor 12 may be mounted to a tip portion 2a of the wind turbine blade 2. For instance, the receptor 12 may be a rod receptor or a disc receptor embedded onto the wind turbine blade 2, or a solid receptor forming the tip portion 2a of the wind turbine blade 2, for instance. Furthermore, the receptor 12 may be mounted between the tip portion 2a and a blade root 2b of the wind turbine blade 2.

The down-conductor 14 may be formed from a conductive material, and connected to an earth terminal disposed on a platform of the tower 6, extending from the receptor 12 through the wind turbine blade 2, the nacelle 5, and the tower 6.

In a case where the wind turbine 1 includes the lightning protection device 10 having the above configuration, electrical continuity may fail due to erosion or corrosion of the receptor 12, for instance. In this case, upon receipt of a lightning strike, sparks may be generated to cause serious damage.

A method for testing whether continuity of the receptor 12 is ensured will be described below.

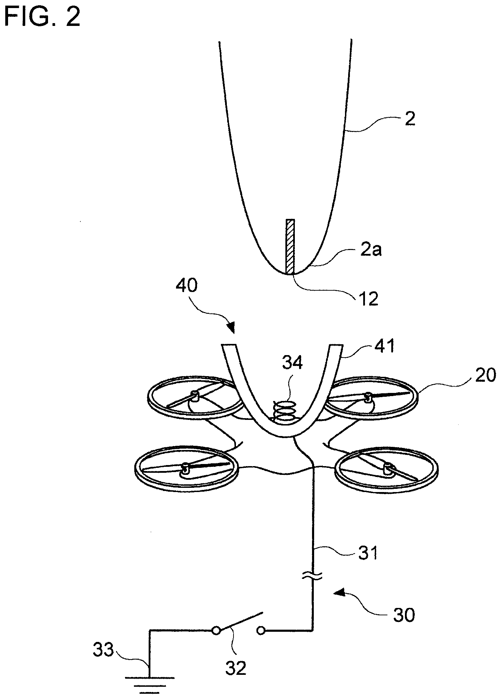

FIGs. 2 to 15 are each a schematic diagram showing a method of testing the receptor 12 according to the embodiment and the examples serving to explain features of the invention.

As depicted in FIGs. 2 to 15, a method of testing the receptor 12 according to the embodiment and the examples serving to explain features of the invention includes a step of testing electrical continuity of the receptor 12 by moving an unmanned aerial vehicle (UAV) 20 toward the receptor 12 of the wind turbine blade 2 mounted to the hub 3 (see FIG. 1) of the wind turbine 1.

Using the UAV 20 to test the receptor 12 mounted to the wind turbine blade 2 makes it easier to approach the receptor 12 of the wind turbine blade 2 mounted to the hub 3, and to perform an electric continuity test on the receptor 12 readily. Thus, it is possible to shorten the testing time, as well as to reduce the testing costs, as compared to an electric continuity test using a vehicle for work at height.

Furthermore, the UAV 20 refers to an unmanned aerial vehicle in general. The UAV 20, for instance, may be an unmanned aerial vehicle utilizing a radio remote control. In this case, workers may perform a remote control around the wind turbine 1, or inside the wind turbine 1. Alternatively, the UAV 20 may be an unmanned aerial vehicle that does not require a remote control and is capable of autonomous flight.

Furthermore, the UAV 20 may be a rotorcraft provided with a plurality of rotors, being an unmanned aerial vehicle of a multi-copter type, configured to be controllable to move, stop, and the like, by controlling the rotation speeds of the respective rotors.

With reference to FIGs. 2 to 15, the above described method of testing the receptor 12 further includes a step of forming an electric continuity test circuit 30 including the receptor 12 by using the UAV 20.

In a step of performing an electric continuity test, a voltage is applied to the electric continuity test circuit 30.

Accordingly, the electric continuity test circuit 30 including the receptor 12 can be readily formed by using the UAV 20, and thereby it is possible to improve the efficiency of continuity test works for the receptor 12.

In the embodiment and the examples serving to explain features of the invention, as depicted in FIGs. 2 to 10, the electric continuity test circuit 30 includes a wire 31 mounted to the UAV 20 and being connectible to the receptor 12, a switch 32 connected to the wire 31, and an earth terminal 33 disposed on an end portion of the wire 31. Furthermore, the electric continuity test circuit 30 may further include an electrical contact portion (e.g. spring 34 in FIG. 2) for causing the wire 31 transported by the UAV 20 to make electrical contact with the receptor 12.

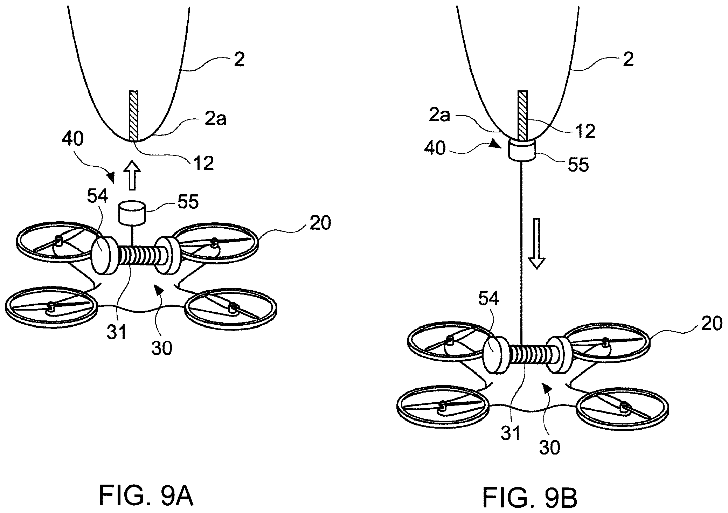

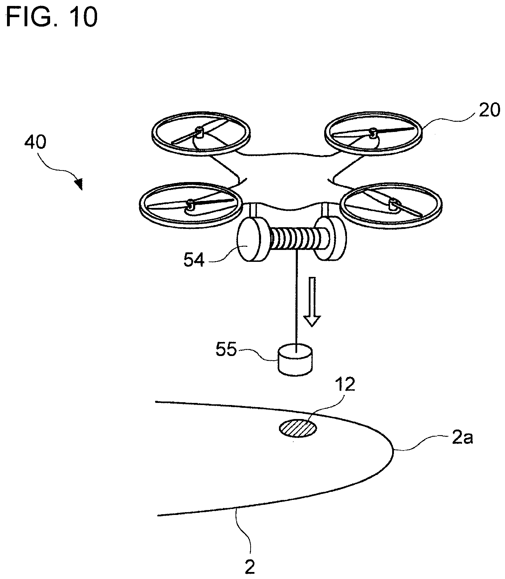

In FIGs. 9 and 10, the switch 32 and the earth terminal 33 are not depicted.

In the embodiment and examples serving to explain features of the invention, as depicted in FIGs. 2 to 10, if the receptor 12 is disposed on the tip portion 2a of the wind turbine blade 2, the above described method of testing the receptor 12 may further include a step of engaging the tip portion 2a of the wind turbine blade 2 with a position determining portion 40 provided for the UAV 20 to retain a relative position of the UAV 20 with respect to the receptor 12.

Accordingly, it is possible to perform works for forming the electric continuity test circuit 30 including the receptor 12 efficiently by using the UAV 20.

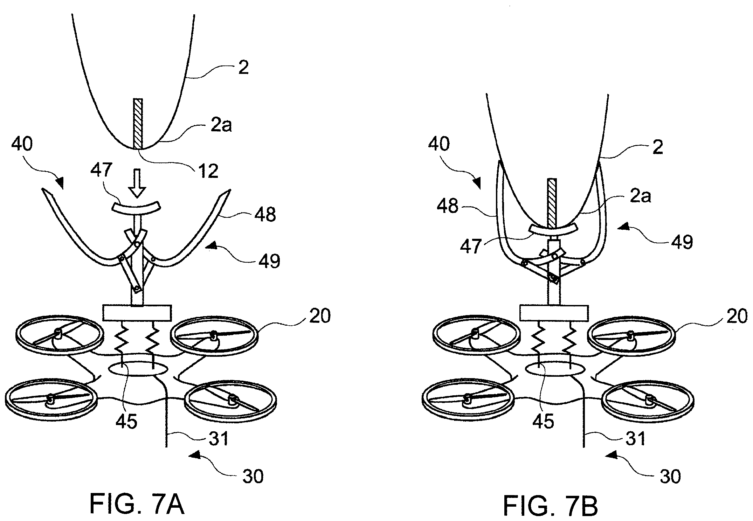

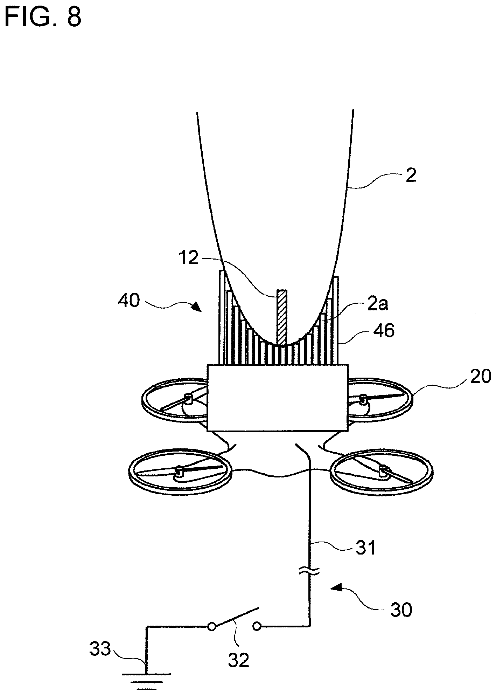

The position determining portion 40 may include at least one of: a cap 41 to be in engagement with the tip portion 2a of the wind turbine blade 2 (see FIG. 2); a clamp 48 configured to nip the tip portion 2a of the wind turbine blade 2 in response to operation of a link mechanism 49 upon being pressed against the tip portion 2a of the wind turbine blade 2 (see FIG. 7); or a shaping portion 46 which is deformable so as to follow the outer shape of the tip portion 2a upon being pressed against the tip portion 2a of the wind turbine blade 2 (see FIG. 8).

Making use of the position determining portion 40 including at least one of: the cap 41 to be in engagement with the tip portion 2a of the wind turbine blade 2 (see FIG. 2); the clamp 48 configured to nip the tip portion 2a of the wind turbine blade 2 (see FIG. 7); or the shaping portion 46 being deformable so as to follow the outer shape of the tip portion 2a (see FIG. 8), makes it possible to retain the relative position of the UAV 20 with respect to the receptor 12 reliably. Accordingly, it is possible to perform works for forming the electric continuity test circuit 30 including the receptor 12 efficiently by using the UAV 20.

Next, the embodiment and the examples serving to explain features of the invention will be described in detail.

In the first example serving to explain features of the invention depicted in FIG. 2, the UAV 20 is provided with a cap 41 to be in engagement with the tip portion 2a of the wind turbine blade 2, which serves as the position determining portion 40. Inside the cap 41, a conductive member, which is an electrical contact portion, is provided. Furthermore, a shock absorbing member may be disposed inside the cap 41. For instance, a metal spring 34 is disposed inside the cap 41, which has functions of both of the electrical contact portion and the shock absorbing member.

In the method of testing the receptor 12 with the above configuration, the UAV 20 is moved close to the wind turbine blade 2, and then the tip portion 2a of the wind turbine blade 2 is engaged with the inside of the cap 41 mounted to the UAV 20. This state is maintained to retain the relative position of the UAV 20 with respect to the receptor 12. At this time, the tip portion 2a of the wind turbine blade 2 is pressed against the spring 34 inside the cap 41. Accordingly, the electric continuity test circuit 30 including the receptor 12 is formed. Further, a voltage is applied to the electric continuity test circuit 30 and an electric continuity test is performed on the receptor 12.

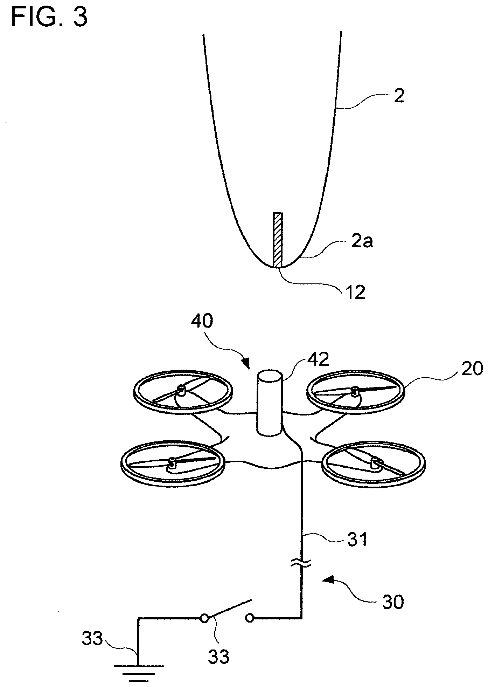

In the second example serving to explain features of the invention depicted in FIG. 3, at least a part of the receptor 12, or at least a part of a portion of the wind turbine blade 2 around the receptor 12 is formed from a magnetic element.

In a case where at least a part of the receptor 12 is formed from a magnetic element, the material of the receptor 12 may be a stainless steel-based material (e.g. SUS430, SUS 410), a copper-based material (e.g. copper, tin, plated copper, hot-tip galvanized copper), a carbon steel, etc. It should be noted that the receptor 12 is made from a material that can bear the composite effect of electrical, thermal, and electronic stresses generated by lightning current.

In a case where a portion around the receptor 12 is formed from a magnetic element, the magnetic element does not need to have conductivity. To prevent lightning current from flowing to portions other than the down-conductor 14 (see FIG. 1) upon receipt of lightning by the receptor 12, it is preferable if the magnetic element is not conductive.

The UAV 20 is provided with a magnetic-force generating part 42.

The magnetic-force generating part 42 may be capable of switching a magnetic force. For instance, the magnetic-force generating part 42 includes an electromagnet or a magnetic chuck, thus being capable of switching ON and OFF of the magnetic force. The magnetic force is turned ON to move the UAV 20 closer to the receptor 12, and is turned OFF to move the UAV 20 away from the magnetic-force generating part 42 after the test is completed.

In the method of testing the receptor 12 with the above configuration, the UAV 20 is moved close to the wind turbine blade 2, and the wire 31 is connected to the receptor 12 to form the electric continuity test circuit 30, while a magnetic force generated by the magnetic-force generating part 42 of the UAV 20 is applied to the magnetic element. An electric continuity test is then performed on the receptor 12 while the relative position of the UAV 20 is fixed with respect to the receptor 12.

Accordingly, at least a part of the receptor 12 or a portion of the wind turbine blade 2 around the receptor 12 is formed by a magnetic element, and the magnetic force generated by the magnetic-force generating part 42 is applied to the magnetic element, which makes it possible to maintain the UAV 20 fixed to the receptor 12 or to a peripheral portion thereof, and thus to improve the efficiency of works for connecting wire to the receptor 12 (works for forming an electric continuity test circuit) by using the UAV 20.

Furthermore, the magnetic-force generating part 42 may be configured to be rotatable with respect to the body of the UAV 20, about two axes orthogonal to the upward-and-downward direction of the UAV 20. In other words, the magnetic-force generating part 42 may be gimbal-supported (not depicted) with respect to the body of the UAV 20. With the magnetic-force generating part 42 being gimbal-supported, the magnetic-force generating part 42 is normally retained in a horizontal position automatically by gravity. When the magnetic-force generating part 42 approaches the receptor 12, the magnetic-force generating part 42 automatically starts to be parallel to the receptor 12 or to the magnetic element portion around the receptor 12, and thus it is possible to cause the magnetic-force generating part 42 to attract and make contact with the receptor 12 or with the magnetic element portion around the receptor 12.

Accordingly, the magnetic-force generating part 42 is configured to be rotatable with respect to the body of the UAV 20, and thus it is possible to attract the magnetic-force generating part 42 toward the magnetic element reliably regardless of the relative attitude of the UAV 20 with respect to the magnetic element (receptor 12 or a peripheral portion thereof), which makes it possible to further improve the efficiency of works for connecting wire to the receptor 12 by using the UAV 20.

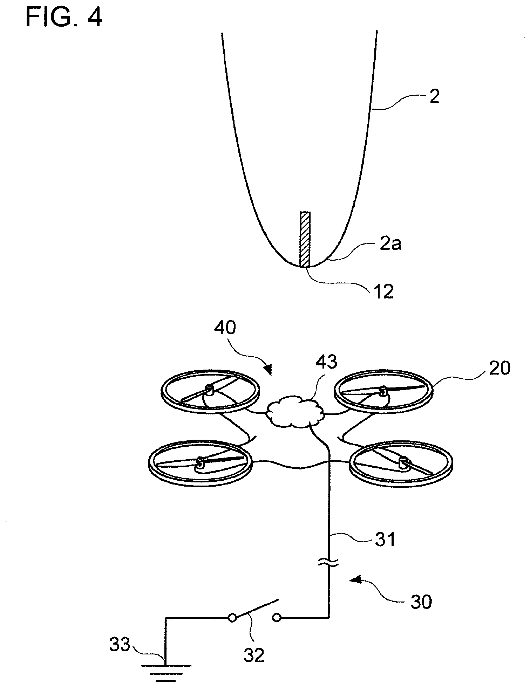

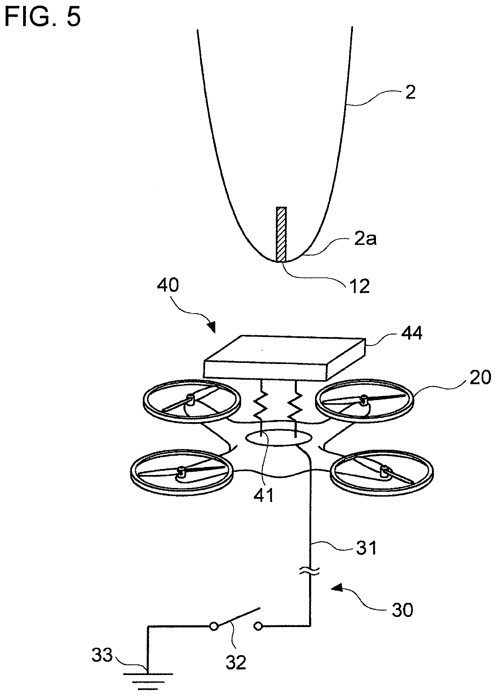

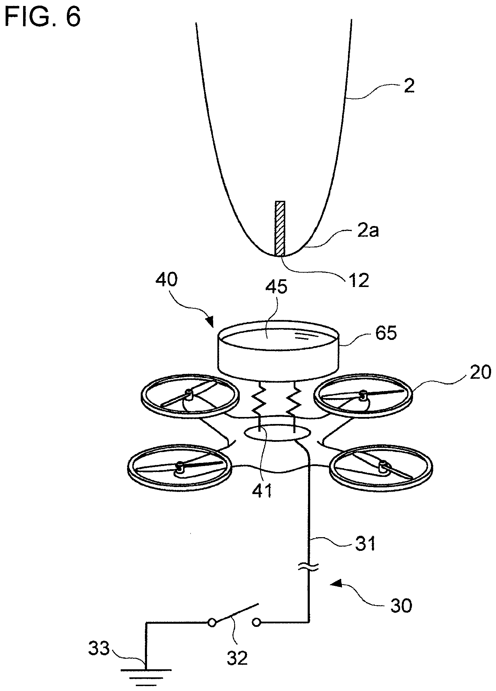

In the examples serving to explain features of the invention depicted in FIGs. 4 to 6, the UAV 20 is provided with a shock absorbing member having a conductive portion at least on the surface side of the shock absorbing member. For instance, a shock absorbing member may be: a conductive adhesive tape 43, or a cushion member containing a conductive adhesive agent as depicted in the third example serving to explain features of the invention in FIG. 4; a conductive sheet 44, a conductive pate, a conductive clay, or a metal scrubber as depicted in the fourth example serving to explain features of the invention in FIG. 5; a conductive gel 45 as depicted in the fifth example serving to explain features of the invention in FIG. 6; or the spring 34 depicted in the first example in FIG. 2, for instance.

In the method of testing the receptor 12 with the above configuration, the UAV 20 is moved close to the wind turbine blade 2, and the receptor 12 is brought into contact with the shock absorbing member provided for the UAV 20. This state is maintained to retain the relative position of the UAV 20 with respect to the receptor 12. At this time, the receptor 12 of the wind turbine blade 2 is pressed against the shock absorbing member. Accordingly, the electric continuity test circuit 30 including the receptor 12 is formed. Further, a voltage is applied to the electric continuity test circuit 30 and an electric continuity test is performed on the receptor 12.

In the method of testing the receptor 12 with this configuration, in the step of forming the electric continuity test circuit 30, the UAV 20 is moved to press the shock absorbing member against the wind turbine blade 2, whereby the wire 31 is connected to the receptor 12 via a conductive portion of the shock absorbing member to form the electric continuity test circuit 30.

Accordingly, it is possible to connect wire to the receptor 12 efficiently via a conductive portion (electrical contact portion) of the shock absorbing member while mitigating shock due to contact between the UAV 20 and the wind turbine blade 2 with the shock absorbing member.

In this method, if a shock absorbing member also having an adhesive property is used, such as the conductive adhesive tape 43 depicted in FIG. 4, the receptor 12 is coupled to the shock absorbing member while the receptor 12 is in contact with the shock absorbing member disposed on the UAV 20. Accordingly, it is possible to retain the relative position of the UAV 20 with respect to the receptor 12 appropriately.

Furthermore, if the conductive sheet 44 depicted in FIG. 5 is used, there is an advantage that electrical continuity of the receptor 12 can be secured without determining the position strictly.

In the fifth example depicted in FIG. 6, the UAV 20 includes a container 65 storing a conductive element in a liquid form, a gel form, or a powder form. In the drawing, a conductive gel 45 is stored in the container 65.

In the method of testing the receptor 12, in the step of forming the electric continuity test circuit, the UAV 20 is moved to put a portion of the wind turbine blade 2 including the receptor 12 into the container 65, whereby the wire 31 is connected to the receptor 12 via the conductive element 61 and the electric continuity test circuit 30 is formed.

Accordingly, it is possible to connect wire to the receptor 12 via the conductive element 61 efficiently, by operating the UAV 20 so that a tip of the wind turbine blade 2 enters the container 60 storing the conductive element 61. Furthermore, if the conductive gel 45 stored in the container 65 is used as depicted in FIG. 6, it is possible to establish secure electric continuity with the receptor 12 by immersing the receptor 12 on the tip of the wind turbine blade 2 into the conductive gel 45, without adjusting the position strictly. The conductive gel 25 has another advantageous that it is less likely to spill out of the container 65 even if the UAV 20 sways.

In the sixth example serving to explain features of the invention depicted in FIG. 7, the UAV 20 is provided with the clamp 48 configured to nip the tip portion 2a of the wind turbine blade 2 in response to operation of the link mechanism 49 upon being pressed against the tip portion 2a of the wind turbine blade 2, the clamp 48 serving as the position determining portion 40. For instance, when the wind turbine blade 2 is pressed against a contact portion 47 coupled to the clamp 48 (see FIG. 7A), the contact portion 47 is pushed down so that the link mechanism 49 operates, and thereby the clamp 48 nips the wind turbine blade 2 (see FIG. 7B). Accordingly, it is possible to retain the relative position of the UAV 20 with respect to the receptor 12. At this time, if the contact portion 47 is formed from a conductive element, for instance, the electric continuity test circuit 30 including the receptor 12 is formed. Further, a voltage is applied to the electric continuity test circuit 30 and an electric continuity test is performed on the receptor 12.

According to this method, it is possible to determine the position appropriately, but the accuracy required is not so high, and thus operation of the UAV 20 is simplified.

In the seventh example serving to explain features of the invention depicted in FIG. 8, the UAV 20 is provided with the shaping portion 46 configured to be deformable so as to follow the outer shape of the tip portion 2a by being pressed against the tip portion 2a of the wind turbine blade 2, the shaping portion 46 serving as the position determining portion 40. For instance, the shaping portion 46 has a plurality of rod members which can extend and contract, thus being configured to deform along the outer shape of the wind turbine blade 2. The shaping portion 46 may have a two-dimensional shape.

According to this method, it is possible to determine the position appropriately, but the accuracy required is not so high, and thus operation of the UAV 20 is simplified.

In the embodiment depicted in FIG. 9, the UAV 20 includes a reel 54 with a wire 31 wound around the reel 54.

In the method of testing the receptor 12, in the step of forming the electric continuity test circuit 30, the UAV 20 is moved close to the wind turbine blade 2 to connect the wire 31 to the receptor 12 (see FIG. 9A), and then the wire 31 is unreeled from the reel 54 (see FIG. 9B).

In this configuration, in the step of forming the electric continuity test circuit 30, after the UAV 20 attaches the wire 31 of the reel 54 to the receptor 12, the UAV 20 may be detached from the reel 54 so that the reel 54 moves downward while unreeling.

Accordingly, it is possible to move the UAV 20 close to the wind turbine blade 2 while the wire 31 is wound around the reel 54, and thus it is possible to prevent a decrease in the attitude stability of the UAV 20 due to a drag that the wire 31 receives if the wire 31 is suspended from the UAV 20 while the UAV moves upward.

Furthermore, the reel 54 is detached from the UAV 20 to unreel and move down after an end of the wire 31 is attached to the receptor 12, and thereby it is possible to form the electric continuity test circuit 30 readily by a worker below the wind turbine blade 2 recovering the other end of the wire 31 and connecting the wire 31 to an earth terminal, for instance.

Furthermore, in the embodiment depicted in FIG. 9, at least a part of the receptor 12, or at least a part of a portion of the wind turbine blade 2 around the receptor 12 is formed from a magnetic element, and at least a part of the receptor 12 is formed from a magnetic element. A magnetic force generated by the magnetic-force generating part 55 attracts the receptor 12 so that the magnetic-force generating part 55 makes contact with the receptor 12.

Furthermore, as depicted in FIG. 10, the UAV 20 may suspend the wire 31 from above to cause the magnetic-force generating part 55 to attract and make contact with the receptor 12, while the wind turbine blade 2 is retained in the horizontal direction.

Furthermore, in the method of testing the receptor 12, in the step of forming the electric continuity test circuit 30, the receptor 12 may be connected to an earth wire via the wire 31 suspended from the UAV 20, and the wire 31 may be detached from the UAV 20 after performing an electric continuity test on the receptor 12.

Accordingly, it is possible to form the electric continuity test circuit 30 readily by connecting the receptor 12 to the earth wire via the wire 31 suspended from the UAV 20. Furthermore, by detaching the wire from the UAV 20 after completion of an electric continuity test, it is possible to improve the attitude stability of the UAV 20 during downward movement of the UAV 20 upon recovery of the UAV 20.

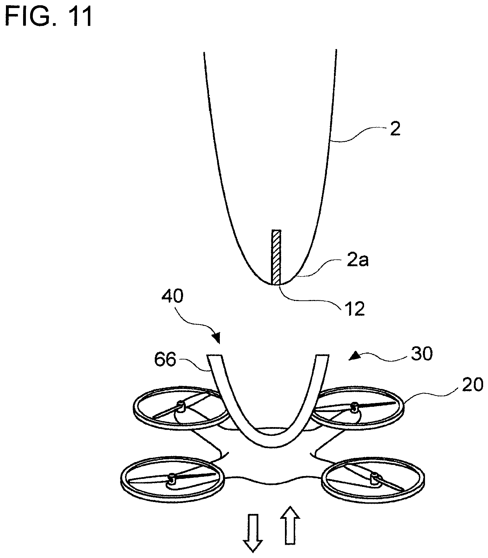

In the eighth example serving to explain features of the invention depicted in FIG. 11, in the step of performing an electric continuity test, a magnetic field applied to the receptor 12 is changed by using the UAV 20 to detect an induction current generated in a circuit from the receptor 12 to the earth wire. For instance, a magnetic field in the vicinity of the receptor 12 may be changed by controlling the UAV 20 provided with the magnetic generating part 66 so as to change the distance between the UAV 20 and the receptor 12.

According to the above method, changing a magnetic field applied to the receptor 12 makes it possible to generate an induction current in a circuit (e.g. the down-conductor 14 depicted in FIG. 1) from the receptor 12 to the earth wire. Thus, it is possible to confirm electrical connection between the receptor 12 and the earth wire by simply detecting an induction current generated in a circuit from the receptor 12 to the earth wire.

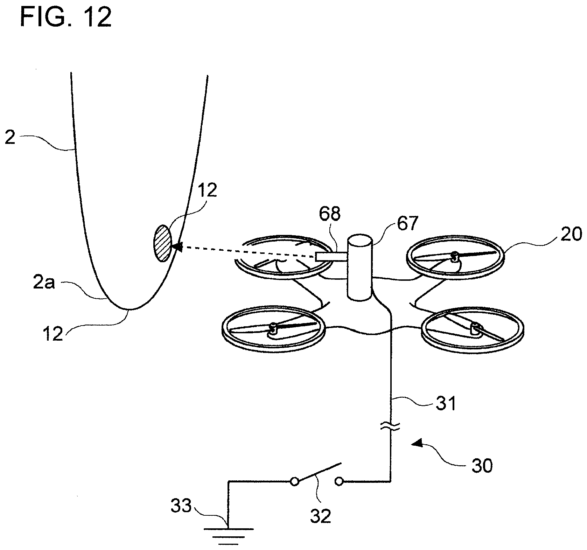

In the ninth example serving to explain features of the invention depicted in FIG. 12, the UAV 20 includes a tank 67 storing a conductive liquid, and a nozzle 68 for injecting water continuously to the receptor 12 from the tank 67.

With this configuration, the method of testing the receptor 12 further includes a step of injecting a conductive liquid from the UAV 20 to the receptor 12.

Furthermore, in the step of forming the electric continuity test circuit 30, the receptor 12 is connected to the wire 31 via a liquid flow of the conductive liquid.

Accordingly, it is possible to form the electric continuity test circuit 30 readily by electrically connecting the receptor 12 to the wire via a liquid flow of the conductive liquid.

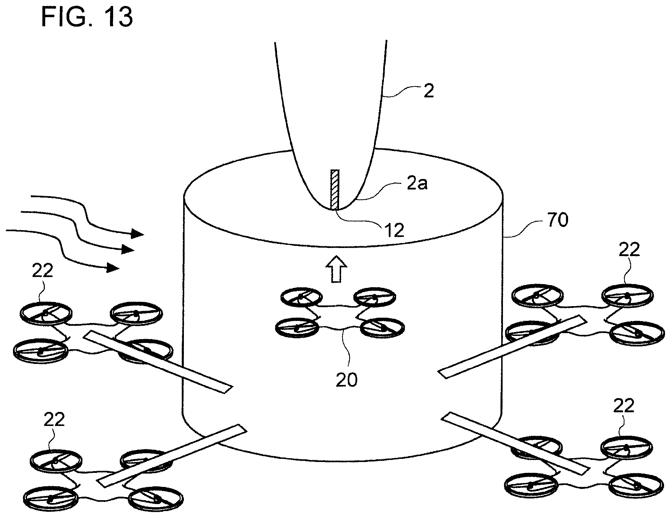

In the tenth example serving to explain features of the invention depicted in FIG. 13, the method of testing the receptor 12 further includes a step of surrounding the UAV 20 with a windshield member 70 mounted to at least one auxiliary UAV 22. The configuration of the UAV 20 for performing an electric continuity test may be employed from any one of the embodiment and the examples depicted in FIGs. 2 to 12, and is not described here again in detail.

Accordingly, the UAV 20 is covered with the windshield member 70 mounted to the at least one auxiliary UAV 22, and thus it is possible to maintain the attitude stability of the UAV 20 without being affected by wind, while the UAV 20 approaches the receptor 12, or while the UAV 20 is in a standby state near the receptor 12.

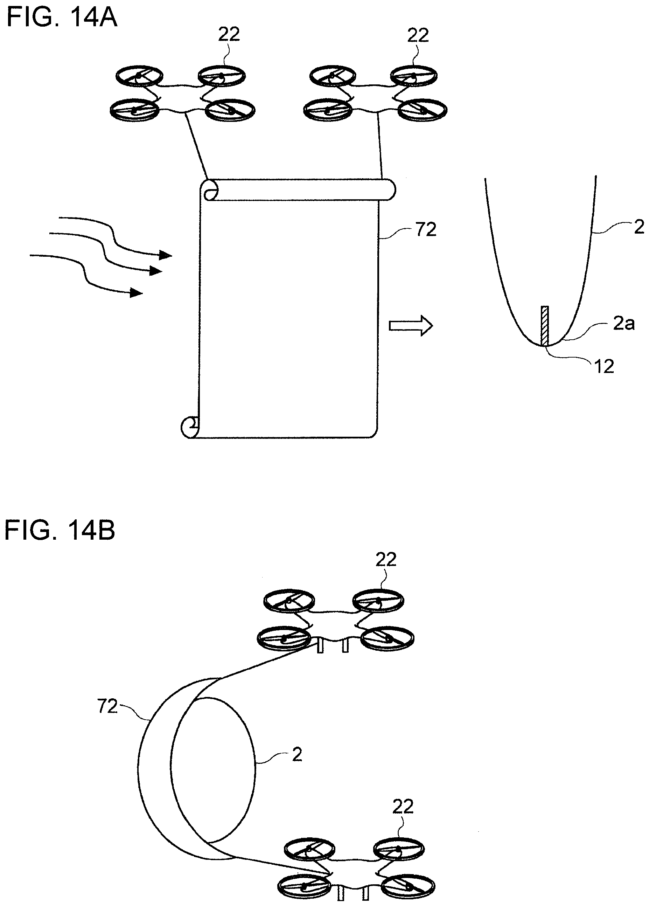

In the eleventh example serving to explain features of the invention depicted in FIG. 14, in the step of forming the electric continuity test circuit 30, while a conductive cloth member 72 constituting a part of the electric continuity test circuit 30 is suspended from the at least one UAV 22, the UAV 22 is moved close to the wind turbine blade 2 from the upwind side (see FIG. 14A), and the conductive cloth member 72 is pressed against a portion of the wind turbine blade 2 including the receptor 12 by utilizing wind (see FIG. 14B).

Accordingly, it is possible to form the electric continuity test circuit 30 readily by hanging the conductive cloth member 72from the UAV 22, moving the UAV 22 toward the wind turbine blade 2 from the upwind side, and pressing the conductive cloth member 72 against the receptor 12 by making use of wind. FIG. 14B is a top view of FIG. 14A.

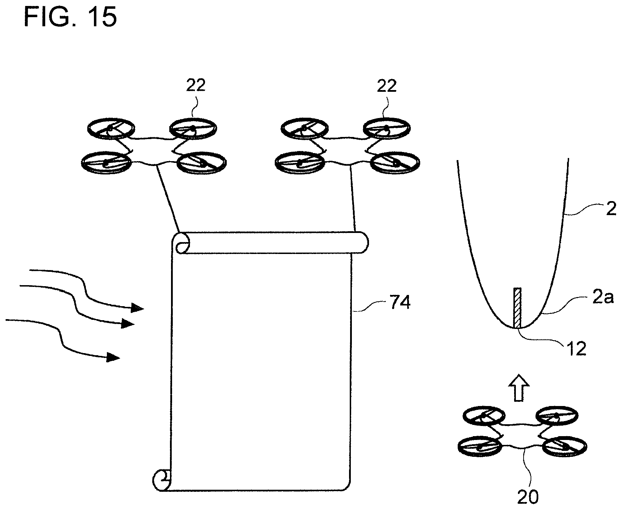

In the twelfth example serving to explain features of the invention depicted in FIG. 15, in the step of forming the electric continuity test circuit 30, a windshield cloth 74 may be suspended from the at least one UAV 22, and the UAV 20 may be moved close to the wind turbine blade 2 from the upwind side.

As described above, according to the embodiment of the present invention and the examples serving to explain features of the invention, using the UAV 20 to test the receptor 12 of the wind turbine makes it easier to approach the receptor 12 of the wind turbine blade 2 mounted to the hub 3, and to perform an electric continuity test on the receptor 12 readily. Thus, it is possible to shorten the testing time, as well as to reduce the testing costs, as compared to an electric continuity test using a vehicle for work at height.

The Embodiment of the present invention and the examples serving to explain features of the invention were described in detail above, but the present invention is not limited thereto, and various amendments and modifications may be implemented.

For instance, an expression of relative or absolute arrangement such as "in a direction", "along a direction", "parallel", "orthogonal", "centered", "concentric" and "coaxial" shall not be construed as indicating only the arrangement in a strict literal sense, but also includes a state where the arrangement is relatively displaced by a tolerance, or by an angle or a distance whereby it is possible to achieve the same function.

For instance, an expression of an equal state such as "same" "equal" and "uniform" shall not be construed as indicating only the state in which the feature is strictly equal, but also includes a state in which there is a tolerance or a difference that can still achieve the same function.

Further, for instance, an expression of a shape such as a rectangular shape or a cylindrical shape shall not be construed as only the geometrically strict shape, but also includes a shape with unevenness or chamfered corners within the range in which the same effect can be achieved.

On the other hand, an expression such as "comprise", "include", "have", "contain" and "constitute" are not intended to be exclusive of other components.

## Claims

1. A method of testing a lightning receiving receptor (12) of a wind turbine (1), the method comprising:
a step of forming an electric continuity test circuit (30) including the lightning receiving receptor (12) by moving an unmanned aerial vehicle (UAV) (20), which includes a reel (54) provided with a wire (31) wound around the reel (54), close to the lightning receiving receptor (12) of a wind turbine blade (2) mounted to a hub (3) of the wind turbine (1) to connect the wire (31) to the lightning receiving receptor (12), and unwinding the wire (31) from the reel (54), and
a step of performing an electric continuity test on the lightning receiving receptor (12) which includes applying a voltage to the electric continuity test circuit (30) which comprises the lightning receiving receptor (12) and the wire (31) .

2. The method of testing a lightning receiving receptor (12) of a wind turbine (1) according to claim 1,
wherein the lightning receiving receptor (12) is disposed on a tip portion (2a) of the wind turbine blade (2), and
wherein the method further comprises a step of engaging the tip portion (2a) of the wind turbine blade (2) with a position-determining portion (40) disposed on the UAV (20) to retain a relative position of the UAV (20) with respect to the lightning receiving receptor (12).

3. The method of testing a lightning receiving receptor (12) of a wind turbine (1) according to claim 2,
wherein the position-determining portion (40) includes at least one of: a cap (41) engageable with the tip portion (2a) of the wind turbine blade (2); a clamp (48) configured to nip the tip portion (2a) of the wind turbine blade (2) in response to operation of a link mechanism (49) by being pressed against the tip portion (2a) of the wind turbine blade (2); or a shaping portion (46) which is deformable so as to follow an outer shape of the tip portion (2a) by being pressed against the tip portion (2a) of the wind turbine blade (2).

4. The method of testing a lightning receiving receptor (12) of a wind turbine (1) according to any one of claims 1 to 3,
wherein at least a part of the lightning receiving receptor (12), or at least a part of a portion of the wind turbine blade (2) around the lightning receiving receptor (12) is formed by a magnetic element, and
wherein the step of forming the electric continuity test circuit (30) includes connecting the wire (31) to the lightning receiving receptor (12) while applying a magnetic force generated by a magnetic-force generating part (55) disposed on the UAV (20) to the magnetic element.

5. The method of testing a lightning receiving receptor (12) of a wind turbine (1) according to claim 4,
wherein the magnetic-force generating part (55) is rotatable relative to a body of the UAV (20) about two axes orthogonal to an upward-and-downward direction of the UAV (20) .

6. The method of testing a lightning receiving receptor (12) of a wind turbine (1) according to any one of claims 1 to 5,
wherein the UAV (20) includes a shock absorbing member including a conductive portion at least on a surface side of the shock absorbing member, and
wherein the step of forming the electric continuity test circuit (30) includes forming the electric continuity test circuit (30) by moving the UAV (20) to press the shock absorbing member against the wind turbine blade (2) and connect the wire (31) to the lightning receiving receptor (12) via the conductive portion of the shock absorbing member.

7. The method of testing a lightning receiving receptor (12) of a wind turbine (1) according to any one of claims 1 to 6,
wherein the UAV (20) includes a container (65) storing a conductive element in a liquid form, a gel form or a powder form, and
wherein the step of forming the electric continuity test circuit includes forming the electric continuity test circuit (30) by moving the UAV (20) to cause a portion of the wind turbine blade (2) including the lightning receiving receptor (12) to enter the container (65) and connect the wire (31) to the lightning receiving receptor (12) via the conductive element.

8. The method of testing a lightning receiving receptor (12) of a wind turbine (1) according to any one of claims 1 to 7,
wherein the step of forming the electric continuity test circuit (30) includes attaching the wire (31) of the reel (54) to the receptor (12) by using the UAV (20), detaching the UAV (20) from the reel (54), and allowing the reel (54) to unreel and move downward.

9. The method of testing a lightning receiving receptor (12) of a wind turbine (1) according to any one of claims 1 to 7,
wherein the step of forming the electric continuity test circuit (30) includes connecting the lightning receiving receptor (12) to an earth wire via the wire (31) suspended from the UAV (20), and
wherein the method further comprises a step of detaching the wire (31) from the UAV (20), after performing the electric continuity test on the lightning receiving receptor (12) .

10. The method of testing a lightning receiving receptor (12) of a wind turbine (1) according to any one of claims 1 to 9,
further comprising a step of surrounding the UAV (20) with a wind shield member (70) mounted to at least one auxiliary UAV (22).

## Patentansprüche

1. Ein Verfahren zum Prüfen eines Blitzaufnahmeempfängers (12) einer Windturbine (1), wobei das Verfahren aufweist:
einen Schritt des Ausbildens eines elektrischen Durchgangs-Testkreises (30) mit dem Blitzaufnahmeempfänger (12) durch Bewegen eines unbemannten Luftfahrzeugs (UAV) (20), das eine Spule (54) umfasst, die mit einem Draht oder Kabel (31), das um die Spule (54) herum gewickelt ist, versehen ist, nahe zu dem Blitzaufnahmeempfänger (12) einer Windturbinenschaufel (2), die an einer Nabe (3) der Windturbine (1) angebracht ist, um den Draht oder das Kabel (31) mit dem Blitzaufnahmeempfänger (12) zu verbinden, und Abwickeln des Drahts oder Kabels (31) von der Spule (54), und
einen Schritt des Ausführens eines elektrischen Durchgangstests an dem Blitzaufnahmeempfänger (12), der ein Anlegen einer Spannung an dem elektrischen Durchgangstestkreis (30), welcher den Blitzaufnahmeempfänger (12) und den Draht oder das Kabel (31) umfasst, enthält.

2. Das Verfahren zum Prüfen eines Blitzaufnahmeempfängers (12) einer Windturbine (1) gemäß Anspruch 1,
wobei der Blitzaufnahmeempfänger (12) an einem Außenendabschnitt (2a) der Windturbinenschaufel (2) angeordnet ist, und
wobei das Verfahren ferner einen Schritt des in Eingriff Bringens des Außenendabschnitts (2a) der Windturbinenschaufel (2) mit einem Positionsbestimmungsabschnitt (40) aufweist, welcher an dem UAV (20) angeordnet ist, um eine Relativposition des UAV (20) bezüglich dem Blitzaufnahmeempfänger (12) zu halten.

3. Das Verfahren zum Prüfen eines Blitzaufnahmeempfängers (12) einer Windturbine (1) gemäß Anspruch 2,
wobei der Positionsbestimmungsabschnitt (40) zumindest eines der folgenden aufweist:
eine Abdeckung (41), die mit dem Außenendabschnitt (2a) der Windturbinenschaufel (2) in Eingriff bringbar ist, eine Klemme oder Klammer (48), die konfiguriert ist, um den Außenendabschnitt (2a) der Windturbinenschaufel (2) in Reaktion auf einen Betrieb eines Verbindungsmechanismus (49) zu klemmen, indem sie gegen den Außenendabschnitt (2a) der Windturbinenschaufel (2) gedrückt wird, oder einen Formungsabschnitt (46), der so verformbar ist, dass er einer Außenform des Außenendabschnitts (2a) folgt, indem er gegen den Außenendabschnitt (2a) der Windturbinenschaufel (2) gedrückt wird.

4. Das Verfahren zum Prüfen eines Blitzaufnahmeempfängers (12) einer Windturbine (1) gemäß einem der Ansprüche 1 bis 3,
wobei zumindest ein Teil des Blitzaufnahmeempfängers (12) oder zumindest ein Teil eines Abschnitts der Windturbinenschaufel (2) um den Blitzaufnahmeempfänger (12) herum durch ein magnetisches Element gebildet ist, und
wobei der Schritt des Ausbildens des elektrischen Durchgangstestkreises (30) ein Verbinden des Drahts oder Kabels (31) mit dem Blitzaufnahmeempfänger (12) umfasst, während eine Magnetkraft, die durch ein Magnetkraft-Erzeugungsteil (55) erzeugt wird, welches an dem UAV (20) angeordnet ist, auf das magnetische Element aufgebracht wird.

5. Das Verfahren zum Prüfen eines Blitzaufnahmeempfängers (12) einer Windturbine (1) gemäß Anspruch 4,
wobei das Magnetkraft-Erzeugungsteil (55) relativ zu einem Körper des UAV (20) um zwei Achsen orthogonal zu einer Aufwärts- und Abwärtsrichtung des UAV (20) rotierbar ist.

6. Das Verfahren zum Prüfen eines Blitzaufnahmeempfängers (12) einer Windturbine (1) gemäß einem der Ansprüche 1 bis 5,
wobei das UAV (20) ein Stoßdämpfungselement mit einem leitfähigen Abschnitt zumindest an einer Oberflächenseite des Stoßdämpfungselements aufweist, und
wobei der Schritt des Ausbildens des elektrischen Durchgangstestkreises (30) ein Ausbilden des elektrischen Durchgangstestkreises (30) durch Bewegen des UAV (20) zum Drücken des Stoßdämpfungselements gegen die Windturbinenschaufel (2) und Verbinden des Drahts oder Kabels (31) mit dem Blitzaufnahmeempfänger (12) über den leitfähigen Abschnitt des Stoßdämpfungselements umfasst.

7. Das Verfahren zum Prüfen eines Blitzaufnahmeempfängers (12) einer Windturbine (1) gemäß einem der Ansprüche 1 bis 6,
wobei das UAV (20) einen Behälter (65) umfasst, der ein leitfähiges Element in einer flüssigen Form, einer Gelform oder einer Pulverform speichert, und
wobei der Schritt des Ausbildens des elektrischen Durchgangstestkreises ein Ausbilden des elektrischen Durchgangtestkreises (30) durch Bewegen des UAV (20) zum Bewirken, dass ein Abschnitt der Windturbinenschaufel (2) einschließlich dem Blitzaufnahmeempfänger (12) in den Behälter (65) eintritt und der Draht oder das Kabel (31) mit dem Blitzaufnahmeempfänger (12) über das leitfähige Element verbunden wird, aufweist.

8. Das Verfahren zum Prüfen eines Blitzaufnahmeempfängers (12) einer Windturbine (1) gemäß einem der Ansprüche 1 bis 7,
wobei der Schritt des Ausbildens des elektrischen Durchgangstestkreises (30) ein Anbringen des Drahts oder Kabels (31) der Spule (54) an dem Empfänger (12) durch Verwenden des UAV (20), ein Loslösen des UAV (20) von der Spule (54), und ein Zulassen, dass sich die Spule (54) abwickelt und nach unten bewegt, umfasst.

9. Das Verfahren zum Prüfen eines Blitzaufnahmeempfängers (12) einer Windturbine (1) gemäß einem der Ansprüche 1 bis 7,
wobei der Schritt des Ausbildens des elektrischen Durchgangstestkreises (30) ein Verbinden des Blitzaufnahmeempfängers (12) mit einem Erdungsdraht oder - kabel über den Draht oder das Kabel (31), das von dem UAV (20) herabhängt, umfasst, und
wobei das Verfahren ferner einen Schritt des Loslösens des Drahts oder Kabels (31) von dem UAV (20), nach dem Ausführen des elektrischen Durchgangstests, an dem Blitzaufnahmeempfänger (12), aufweist.

10. Das Verfahren zum Prüfen eines Blitzaufnahmeempfängers (12) einer Windturbine (1) gemäß einem der Ansprüche 1 bis 9,
ferner mit einem Schritt des Umgebens des UAV (20) mit einem Windabschirmelement (70), das an zumindest einem Hilfs-UAV (22) angebracht ist.

## Revendications

1. Procédé de test d'un récepteur (12) de réception d'éclair d'une éolienne (1), le procédé comprenant :
un stade de formation d'un circuit (30) de test de continuité électrique, comprenant le récepteur (12) de réception d'éclair en déplaçant un véhicule aérien sans équipage (UAV) (20), qui comprend une bobine (54) pourvue d'un fil (31) enroulé autour de la bobine (54), près du récepteur (12) de réception d'éclair d'une pale (2) d'une éolienne montée sur un moyeu (3) de l'éolienne pour relier le fil (31) au récepteur (12) de réception d'éclair, et de déroulement du fil à partir de la bobine (54) et
un stade, dans lequel on effectue un test de continuité électrique sur le récepteur (12) de réception d'éclair, qui comprend appliquer une tension au circuit (30) de test de continuité électrique, qui comprend le récepteur (12) de réception d'éclair et le fil (31).

2. Procédé de test d'un récepteur (12) de réception d'éclair d'une éolienne (1) suivant la revendication 1,
dans lequel le récepteur (12) de réception d'éclair est disposé sur une partie (2a) de bout de la pale (2) de l'éolienne, dans lequel le procédé comprend, en outre, un stade dans lequel on fait coopérer la partie (2a) de bout de la pale (2) de l'éolienne avec une partie (40) de détermination de position disposée sur l'UAV (20) pour retenir une position relative de l'UAV (20) par rapport au récepteur (12) de réception d'éclair.

3. Procédé de test d'un récepteur (12) de réception d'éclair d'une éolienne (1) suivant la revendication 2,
dans lequel la partie (40) de détermination de position comprend au moins l'un de : une coiffe (41) pouvant coopérer avec la partie (2a) de bout de la pale (2) de l'éolienne; un collier (48) configuré pour pincer la partie (2a) de bout de la pale (2) de l'éolienne en réaction au fonctionnement d'un mécanisme (49) articulé en étant pressé sur la partie (2a) de bout de la pale (2) de l'éolienne ou une partie (19) de conformation, qui est déformable, de manière à suivre une forme extérieure de la partie (2a) de bout, en étant pressée sur la partie (2a) de bout de la pale (2) de l'éolienne.

4. Procédé de test d'un récepteur (12) de réception d'éclair d'une éolienne (1) suivant l'une quelconque des revendications 1 à 3,
dans lequel une partie du récepteur (12) de réception d'éclair ou au moins une partie d'une partie de la pale (2) de l'éolienne autour du récepteur (12) de réception d'éclair est formée d'un élément magnétique et
dans lequel le stade de formation du circuit (30) de test de continuité électrique comprend connecter le fil (31) au récepteur (12) de réception d'éclair, tout en appliquant une force magnétique produite par une partie (55) de production d'une force magnétique disposée sur l'UAV (20) à l'élément magnétique.

5. Procédé de test d'un récepteur (12) de réception d'éclair d'une éolienne (1) suivant la revendication 4,
dans lequel la partie (55) de production d'une force magnétique peut tourner par rapport à un corps de l'UAV (20) autour de deux axes orthogonaux à une direction vers le haut et vers le base de l'UAV (20).

6. Procédé de test d'un récepteur (12) de réception d'éclair d'une éolienne (1) suivant l'une quelconque des revendications 1 à 5,
dans lequel l'UAV (20) comprend un élément d'absorption des chocs incluant une partie conductrice au moins sur un côté de surface de l'élément d'absorption des chocs et
dans lequel le stade de formation du circuit (30) de continuité électrique comprend former le circuit (30) de test de continuité électrique en déplaçant l'UAV (20) pour presser l'élément d'absorption des chocs sur la pale (2) de l'éolienne et connecter le fil (31) au récepteur (12) de réception d'éclair par l'intermédiaire de la partie conductrice de l'élément d'absorption des chocs.

7. Procédé de test d'un récepteur (12) de réception d'éclair d'une éolienne (1) suivant l'une quelconque des revendications 1 à 6,
dans lequel l'UAV (20) comprend un récipient (65) emmagasinant un élément conducteur sous forme liquide, sous forme de gel ou sous forme de poudre et
dans lequel le stade de formation du circuit de test de continuité électrique comprend la formation du circuit (30) de test de continuité électrique en déplaçant l'UAV (20) pour faire qu'une partie de la pale (2) de l'éolienne, incluant le récepteur (12) de réception d'éclair, entre dans le récipient (65) et connecte le fil (31) au récepteur (12) de réception d'éclair par l'intermédiaire de l'élément conducteur.

8. Procédé de test d'un récepteur (12) de réception d'éclair d'une éolienne (1) suivant l'une quelconque des revendications 1 à 7,
dans lequel le stade de formation du circuit (30) de test de continuité électrique comprend attacher le fil (31) de la bobine (54) au récepteur (12) en utilisant l'UAV (20), détacher l'UAV (20) de la bobine (54) et permettre à la bobine (54) de se dérouler et de se déplacer vers le bas.

9. Procédé de test d'un récepteur (12) de réception d'éclair d'une éolienne (1) suivant l'une quelconque des revendications 1 à 7,
dans lequel le stade de formation du circuit (30) de test de continuité électrique comprend connecter le récepteur (12) de réception d'éclair à un fil de terre, par l'intermédiaire du fil (31) suspendu de l'UAV (20), dans lequel le procédé comprend, en outre, un stade de détachement de l'UAV (20) après avoir effectué le test de continuité électrique sur le récepteur (12) de réception d'éclair.

10. Procédé de test d'un récepteur (12) de réception d'éclair d'une éolienne (1) suivant l'une quelconque des revendications 1 à 9,
comprenant, en outre, un stade dans lequel on entoure l'UAV (20) d'un élément (70) formant bouclier au vent, monté sur au moins un UAV (22) auxiliaire.
